# EUROPÄISCHE PATENTSCHRIFT

(11) **EP 0 701 487 B1**
(45) Veröffentlichungstag und Bekanntmachung des Hinweises auf die Patenterteilung: **25.11.1998**
(21) Anmeldenummer: 93918918.9
(22) Anmeldetag: 26.08.1993
(51) Int. Cl.: B05C 9/02, B05C 11/105, C23C 2/00, H01L 21/00, B05D 1/26

(54) **VORRICHTUNG ZUR BELACKUNG ODER BESCHICHTUNG VON PLATTEN ODER SCHEIBEN**
DEVICE FOR LACQUERING OR COATING PLATES OR PANELS
DISPOSITIF DE LAQUAGE OU D'ENDUCTION DE PLAQUES OU DE PANNEAUX

(30) Priorität: 05.05.1993 DE 9300392 U
(43) Veröffentlichungstag der Anmeldung: 20.03.1996
(73) Patentinhaber: STEAG MicroTech GmbH, 72124 Pliezhausen (DE)
(72) Erfinder: MÜHLFRIEDEL, Eberhard, D-75433 Maulbronn (DE); KÜBELBECK, Armin, D-64625 Bensheim (DE); GERISCH, Torsten, D-76137 Karlsruhe (DE); APPICH, Karl, D-75447 Sternenfels (DE); SZEKERESCH, Jakob, D-75180 Pforzheim (DE); KALLIS, Martin, D-75417 Mühlacker (DE)
(86) Internationale Anmeldenummer: DE9300777
(87) Internationale Veröffentlichungsnummer: WO9425177

(56) Entgegenhaltungen:
- US-A- 2 046 596

## Beschreibung

Die Erfindung betrifft eine Vorrichtung zur Belackung oder Beschichtung eines Substrats mittels eines Kapillarspalts, welcher mit einem flüssigen Beschichtungsmedium gefüllt ist und über dessen oberes Ende das Substrat bei der Beschichtung mit seiner nach unten weisenden, zu belackenden bzw. beschichtenden Oberfläche hinweggeführt wird, so daß durch Kapillar- und Adhäsionswirkung eine dünne Schicht auf dieser Oberfläche abgeschieden wird, wobei oberhalb des Kapillarspalts eine Transportvorrichtung für das zu belackende Substrat vorgesehen ist, um dieses über das obere Ende des Kapillarspalts hinwegzubewegen.

Eine derartige Vorrichtung ist bekannt aus der US-A-2 046 596. Diese zeigt eine Vorrichtung zur Beschichtung eines fortlaufenden Filmbandes aus Zelluloid mit flüssiger Nitrozellulose. Die Vorrichtung weist einen Behälter mit der flüssigen Nitrozellulose auf, und eine Seitenwand dieses Behälters bildet mit einer zu ihr parallelen Platte, die im Behälter befestigt ist, einen Kapillarspalt, durch welchen die Flüssigkeit aus dem Behälter aufsteigt. Die Seitenwand hat oben und dort, wo der Kapillarspalt endet, eine gerade Abschlußkante, und gegen diese wird das Filmband durch einen endlosen Förderriemen gepreßt und über den Kapillarspalt schräg nach oben geführt, so daß es auf dieser Abschlußkante geneigt aufliegt und sich durch Adhäsionskräfte eine Schicht aus Nitrozellulose auf dem Filmband bildet. Eine solche Vorrichtung eignet sich aber nicht für anspruchsvolle Beschichtungen von Platten oder Scheiben, da letztere durch das Anpressen gegen eine Abschlußkante des Kapillarspalts beschädigt werden können, z.B. durch Kratzspuren.

Eine Aufgabe der Erfindung ist es, eine Vorrichtung bereitzustellen, welche sich für Belackungs- und Beschichtungsvorgänge an Platten oder Scheiben eignet.

Nach der Erfindung wird diese Aufgabe bei einer eingangs genannten Vorrichtung dadurch gelöst, daß die Transportvorrichtung als Lineartransportvorrichtung mit einer Haltevorrichtung für ein zu belackendes, als Platte oder Scheibe ausgebildetes Substrat ausgebildet ist, um dieses bei der Belackung oder Beschichtung ohne Berührung mit den Rändern des Kapillarspalts mit geringem Abstand über diesen und dessen Ränder hinwegzuführen.

Zweckmäßige Weiterbildungen der Erfindung sind Gegenstand der abhängigen Ansprüche.

Die Erfindung eignet sich besonders für die Dünnschichttechnik, insbesondere für die Herstellung von LCD-Bildschirmen, Masken für die Halbleiterfertigung, Halbleiter- oder Keramiksubstraten, um dort rechteckige oder runde Platten mit einer gleichmäßigen Schicht aus Lack oder anderen, zunächst flüssigen Medien wie Farbfiltern oder speziellen Schutzschichten zu versehen. Die Platte oder Scheibe wird, mit der zu belackenden Fläche nach unten, mit geringem Abstand über das obere Ende des Kapillarspalts und seiner Ränder hinweggeführt. Der Kapillarspalt liefert den Lack selbsttätig und mit besonders gleichförmiger Geschwindigkeit nach. Durch die Kapillarwirkung steigt der Lack, oder eine sonstige Beschichtungsflüssigkeit, selbsttätig mit konstanter Geschwindigkeit entgegen der Schwerkraft im Kapillarspalt nach oben und tritt an dessen oberem Ende aus. Oberhalb des Kapillarspalts trifft der Lackstrom als schmale Linie auf die zu beschichtende Plattenoberfläche, welche durch die Lineartransportvorrichtung mit gleichförmiger, geringer Geschwindigkeit bewegt wird, wird dort durch Adhäsion festgehalten, lagert sich, abhängig von der Bewegungsgeschwindigkeit der Platte, in einer definierten Schichtdicke auf dieser Oberfläche ab, und beschichtet sie. Durch die Adhäsion des Lackes zur Plattenoberfläche besteht außerdem nicht die Gefahr, daß der Lack nach dem Austritt aus dem Kapillarspalt seitlich wegfließt, wodurch sonst die Gleichmäßigkeit der Schichtdicke verschlechtert werden könnte.

Der Abstand zwischen Kapillarspalt und Substrat bei der Beschichtung beträgt bevorzugt weniger als 0,2 mm.

Mit Vorteil wird der Kapillarspalt gemäß Anspruch 3 ausgebildet, wobei er mit Vorteil weniger als 0,5 mm breit ist.

Eine sehr vorteilhafte Weiterbildung der Erfindung ist dadurch gekennzeichnet, daß eine Verstellvorrichtung zur stufenlosen Veränderung der Breite des Kapillarspalts vorgesehen ist, welche eine Verstellung der Kapillarspaltbreite während des Betriebs der Vorrichtung ermöglicht. Somit kann ein Kapillarspalt gebildet werden, welcher über seine ganze Länge die für die Kapillarwirkung am besten geeignete Breite hat. Dadurch kann die Kapillargeometrie an die verschiedenen zu beschichtenden Plattenarten angepaßt werden.

In bevorzugter Weise wird die Vorrichtung so weitergebildet, daß Mittel vorgesehen sind, um nach jedem Belackungsvorgang den Kapillarspalt zu öffnen, bevorzugt auf eine Breite von 2 bis 3 mm. Dadurch wird das selbsttätige Aufsteigen des Lacks im Kapillarspalt, das außerhalb des Belackungsvorganges unerwünscht ist, unterbunden. Es hat sich gezeigt, daß der Lack bei längerem Verweilen in dem Kapillarspalt seine Eigenschaften verändert, was sich nachteilig auf das Belackungsergebnis auswirkt. Wird der Kapillarspalt auf 2 bis 3 mm verbreitert, so bleibt der darin verbliebene Lack unverändert.

Eine weitere vorteilhafte Weiterbildung der Erfindung ist dadurch gekennzeichnet, daß Mittel vorgesehen sind, um den Kapillarspalt unmittelbar vor Beginn jedes Belackungs- oder Beschichtungsvorganges auf Kapillarbreite zu verengen, eine kleine Menge des flüssigen Beschichtungsmediums oben aus dem Kapillarspalt herauszudrücken, und damit die Belackung oder Beschichtung in Gang zu bringen. Durch diese mechanische Verengung des Kapillarspalts wird der im Kapillarspalt befindliche Lack zunächst mechanisch nach oben gedrückt, bis er aus dessen oberem Ende austritt und auf die dort befindliche, zu beschichtende Plattenoberfläche auftrifft. Dadurch wird der Belackungsvorgang in Gang gesetzt, der anschließend durch die Kapillarwirkung in dem nunmehr kapillarförmigen Spalt, durch die Bewegung der Platte, und durch die Adhäsionswirkung, in der oben beschriebenen Weise fortgesetzt wird.

Ausführungsbeispiele der Erfindung sind in der Zeichnung dargestellt und werden im folgenden näher beschrieben.

Es zeigt:
- Fig. 1: eine Ansicht des Aufbaus einer erfindungsgemäßen Belackungs- und Beschichtungsvorrichtung, und
- Fig. 2: einen Querschnitt durch eine Rinne mit Kapillarspalt nach Fig. 1 zu Beginn eines Beschichtungsvorgangs.

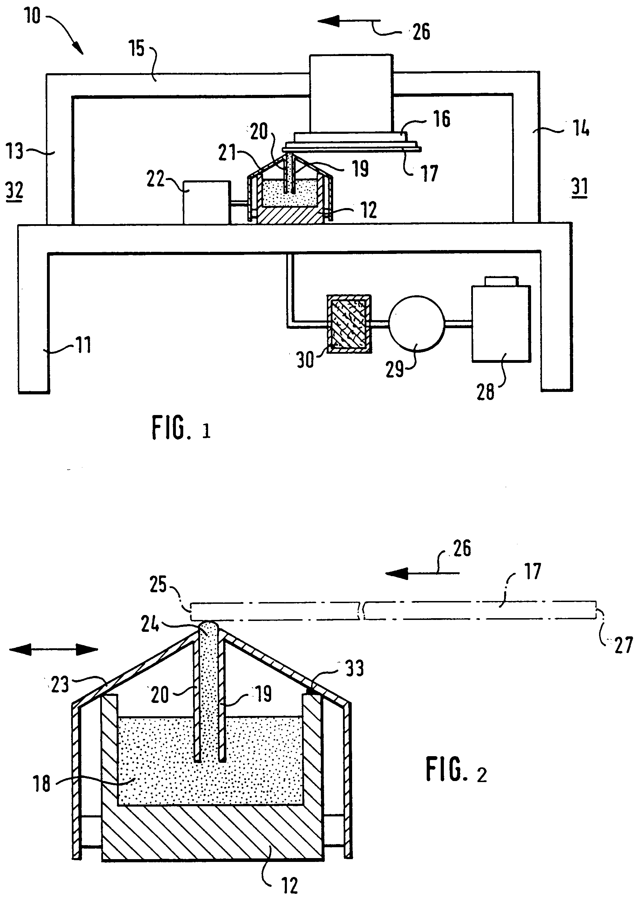

Fig. 1 zeigt ein erstes Ausführungsbeispiel einer erfindungsgemäßen Beschichtungsvorrichtung 10. Auf einem Gestell 11 sind sowohl eine Rinne 12 als auch Ständer 13 und 14 für eine Lineartransporteinheit 15 befestigt. Der bewegliche Teil der Lineartransporteinheit 15 zeigt nach unten. Daran ist eine drehbare Haltevorrichtung 16 für eine zu belackende Platte 17 befestigt. Die Platte 17 ist z.B. eine Glasplatte, die mit Lack beschichtet werden soll, um anschließend eine Maske oder einen LCD-Bildschirm herszustellen. Die Platte 17 wird z.B. durch Vakuum an der Plattenhaltevorrichtung 16 festgesaugt. Dazu hat die Haltevorrichtung 16 entsprechende, nicht dargestellte Vakuumbohrungen.

Im Rahmen der Erfindung können aber auch andere Haltevorrichtungen verwendet werden, wie sie dem Fachmann bekannt sind.

Die Rinne 12 ist im Querschnitt in Fig. 1, und vergrößert in Fig. 2 dargestellt. Der Hohlraum 18 in der Rinne 12 ist teilweise mit Lack gefüllt. In diese Lackfüllung tauchen von oben zwei dünne Platten 19 und 20 ein. Die Platte 19 ist an einer Stelle 33 fest mit der Oberkante der Rinne 12 verbunden. Sie ist nicht beweglich. Dagegen ist die Platte 20 über eine geeignete Vorrichtung mit einer Verstellvorrichtung in Form einer Linearbewegungseinheit 22 verbunden. Über die Bewegungseinheit 22 läßt sich die Platte 20 in Richtung des Pfeiles hin- und herbewegen. Dadurch kann die Breite des Spaltes 24 zwischen den Platten 19 und 20 stufenlos eingestellt werden.

Für optimale Belackungs- oder Beschichtungsergebnisse muß die jeweilige Beschichtungsflüssigkeit eine bestimmte Temperatur aufweisen und sehr sauber sein. Sie wird deshalb auf einem Vorratstank 28 über eine Temperiereinheit 29 und einen Filter 30 in die Rinne 12 gefördert. Die Förderung kann z.B. durch die Erzeugung eines Überdruckes (Gaspolster) im Vorratsbehälter 28 erfolgen, oder durch eine geeignete Anordnung des Vorratsbehälters 28, so daß die Flüssigkeit durch den geodätischen Höhenunterschied in die Rinne 12 gefördert wird. Es sind jedoch auch andere Möglichkeiten des Flüssigkeitstransports möglich, wie sie dem Fachmann bekannt sind.

Für eine voll automatisierte Version der Beschichtungsvorrichtung wird an der mit 31 gekennzeichneten Stelle eine automatische Beladevorrichtung, und an der mit 32 gekennzeichneten Stelle eine automatische Entladevorrichtung montiert. Die Beladevorrichtung 31 entnimmt eine zu belackende Platte 17 aus einem an einer bestimmten Stelle aufgesetzten Magazin und führt sie der Plattenhaltevorrichtung 16 zu. Die Entladevorrichtung 32 übernimmt die Platte 17 von der Haltevorrichtung 16 und lädt sie wiederum in ein an einer bestimmten Stelle aufgesetztes Magazin.

### Arbeitsweise der Belackungs- und Beschichtungsvorrichtung 10

Zunächst wird eine Platte 17 entweder auftomatisch oder manuell an der Haltevorrichtung 16 befestigt. Durch Drehung der Haltevorrichtung 16 kann diese Position noch korrigiert werden. Der Plattenhalter 16 befindet sich zu diesem Zeitpunkt in der Nähe der Stelle, die in Fig. 1 mit 31 gekennzeichnet ist. Ist die Platte 17 in der richtigen Position an der Haltevorrichtung 16 befestigt, so setzt sich die Lineartransporteinheit 15 in Richtung des mit 26 gekennzeichneten Pfeils, also in Richtung auf die Rinne 12, in Bewegung.

Die Platte 17 wird auf diese Weise von der Seite her an die Oberkante des Kapillarspalts 24 herangeführt. Sobald die vordere Kante 25 der Platte 17 direkt oberhalb des Spaltes 24 steht, wird die Platte 20 in der Rinne 12 so weit an die Platte 19 heranbewegt, daß zwischen ihnen die geeignete Kapillarspaltbreite entsteht. Durch diese Verengung des Spaltes 24 wird eine kleine Menge Flüssigkeit aus der Oberseite des Spaltes 24 heraus gegen die vorderste Linie der zu beschichtenden Oberfläche der Platte 17 gedrückt. Damit hat der Beschichtungsvorgang begonnen. Die Platte 17 wird nun durch die Lineartransporteinheit 15 in Richtung des Pfeiles 26 mit gleichförmiger Geschwindigkeit weiterbewegt. Dabei lagert sich durch Adhäsion eine dünne Flüssigkeitsschicht auf der Plattenoberfläche an. Der notwendige Flüssigkeitsstrom wird durch die Kapillarwirkung im Kapillarspalt 24 nachgeliefert.

Der Beschichtungsvorgang ist beendet, sobald die hintere Kante 27 der Platte 17 den Kapillarspalt 24 passiert hat. Danach werden die beiden Platten 19 und 20 bis zum Beginn des nächsten Beschichtungsvorgangs aus den oben genannten Gründen auf einen Abstand von 2 ... 3 mm auseinanderbewegt. Die beschichtete Platte 17 fährt weiter zu dem mit 24 gekennzeichneten Bereich, wo sie automatisch oder manuell von der Haltevorrichtung 16 gelöst wird.

## Patentansprüche

1. Vorrichtung zur Belackung oder Beschichtung eines Substrats (17) mittels eines Kapillarspalts (24), welcher mit einem flüssigen Beschichtungsmedium gefüllt ist und über dessen oberes Ende das Substrat (17) bei der Beschichtung mit seiner nach unten weisenden, zu belackenden bzw. beschichtenden Oberfläche hinweggeführt wird, so daß durch Kapillar- und Adhäsionswirkung eine dünne Schicht auf dieser Oberfläche abgeschieden wird, wobei oberhalb des Kapillarspalts (24) eine Transportvorrichtung (15) für das zu belackende Substrat (17) vorgesehen ist, um dieses über das obere Ende des Kapillarspalts (24) hinwegzubewegen,
dadurch gekennzeichnet, daß die Transportvorrichtung als Lineartransportvorrichtung (15) mit einer Haltevorrichtung (16) für ein zu belackendes, als Platte oder Scheibe ausgebildetes Substrat (17) ausgebildet ist, um dieses bei der Belackung oder Beschichtung ohne Berührung mit den Rändern des Kapillarspalts (24) mit geringem Abstand über diesen und dessen Ränder hinwegzuführen.

2. Vorrichtung nach Anspruch 1, dadurch gekennzeichnet, daß der Abstand zwischen Kapillarspalt (24) und Substrat (17) bei der Beschichtung weniger als 0,2 mm beträgt.

3. Vorrichtung nach Anspruch 1 oder 2, dadurch gekennzeichnet, daß der Kapillarspalt (24) zwei parallele Platten (19, 20) aufweist, die beide in eine flüssiges Beschichtungsmedium enthaltende Rinne (12) eintauchen.

4. Vorrichtung nach Anspruch 2 oder 3, dadurch gekennzeichnet, daß der Kapillarspalt (24) weniger als 0,5 mm breit ist.

5. Vorrichtung nach einem oder mehreren der vorhergehenden Ansprüche, dadurch gekennzeichnet, daß eine Verstellvorrichtung (22) zur stufenlosen Veränderung der Breite des Kapillarspalts (24) vorgesehen ist, welche eine Verstellung der Kapillarspaltbreite während des Betriebs der Vorrichtung ermöglicht.

6. Vorrichtung nach Anspruch 5, dadurch gekennzeichnet, daß Mittel vorgesehen sind, um nach jedem Belackungsvorgang den Kapillarspalt (24) zu öffnen.

7. Vorrichtung nach Anspruch 6, dadurch gekennzeichnet, daß die Verstellvorrichtung (22) zur Öffnung des Kapillarspalts (24) auf eine Breite von 2 bis 3 mm ausgebildet ist.

8. Vorrichtung nach Anspruch 6 oder 7, dadurch gekennzeichnet, daß Mittel vorgesehen sind, um den Kapillarspalt unmittelbar vor Beginn jedes Belackungs- oder Beschichtungsvorgangs auf Kapillarspaltbreite zu verengen, eine kleine Menge des flüssigen Beschichtungsmediums oben aus dem Kapillarspalt (24) herauszudrücken, und damit die Belackung oder Beschichtung der Platte oder Scheibe (17) in Gang zu bringen.

9. Vorrichtung nach einem oder mehreren der vorhergehenden Ansprüche, dadurch gekennzeichnet, daß sie mit einer automatischen Beladestation (31) und einer automatischen Entladestation (32) versehen ist.

10. Vorrichtung nach einem oder mehreren der vorhergehenden Ansprüche, dadurch gekennzeichnet, daß sie mit feststehender Haltevorrichtung (16) und beweglicher Beschichtungsrinne (12) betreibbar ist.

11. Verwendung einer Vorrichtung nach einem oder mehreren der vorhergehenden Ansprüche bei der Herstellung von LCD-Bildschirmen, Masken für die Halbleiterherstellung, oder von Halbleiter- oder Keramiksubstraten.

## Claims

1. Device for lacquering or coating a substrate (17) by means of a capillary gap (24), which is filed with a liquid coating medium and over the upper end of which the substrate (17) is, during the coating, guided past by its downwardly facing surface to be lacquered or coated, so that a thin layer is deposited on this surface by capillary and adhesive action, wherein a transport device (15) for the substrate (17) to be lacquered is provided above the capillary gap (24) in order to move this substrate past over the upper end of the capillary gap (24), characterised in that the transport device is constructed as a linear transport device (15) with a holding device (16) for a substrate (17), which is formed as a plate or disc and is to be lacquered, in order during the lacquering or coating to guide this past without contact with the edges of the capillary gap (24) at a small spacing above this and the edges thereof.

2. Device according to claim 1, characterised in that the spacing between the capillary gap (24) and substrate (17) during the coating amounts to less than 0.2 millimetres.

3. Device according to claim 1 or 2, characterised in that the capillary gap (24) has two parallel plates (19, 20), which both dip into a channel (12) containing liquid coating medium.

4. Device according to claim 2 or 3, characterised in that the capillary gap (24) is smaller than 0.5 millimetres wide.

5. Device according to one or more of the preceding claims, characterised in that an adjusting device (22) for stepless variation in the width of the capillary gap (24) is provided and enables an adjustment of the capillary gap width during operation of the device.

6. Device according to claim 5, characterised in that means are provided in order to open the capillary gap (24) after each lacquering process.

7. Device according to claim 6, characterised in that the adjusting device (22) is constructed for opening the capillary gap (24) to a width of 2 to 3 millimetres.

8. Device according to claim 6 or 7, characterised in that means are provided in order to narrow the capillary gap directly before the beginning of each lacquering or coating process to capillary gap width, to force out a small quantity of the liquid coating medium from the capillary gap (24) at the top and thereby to bring the lacquering or coating of the plate or disc (17) into action.

9. Device according to one or more of the preceding claims, characterised in that it is provided with an automatic charging station (31) and an automatic discharging station (32).

10. Device according to one or more of the preceding claims, characterised in that it is operable with a stationary holding device (16) and a movable coating channel (12).

11. Use of a device according to one or more of the preceding claims in the production of LCD display screens, masks for semiconductor manufacture, or of semiconductor or ceramic substrates.

## Revendications

1. Dispositif pour le laquage ou l'enduction d'un substrat (17 au moyen d'une fente capillaire (24), qui est rempli d'un fluide liquide d'enduction et sur l'extrémité supérieure duquel le substrat est conduit lors de l'enduction avec sa surface à laquer ou respectivement à enduire tournée vers le bas de façon que, par effet capillaire et d'adhérence, une couche mince soit séparée sur cette surface et au-dessus de la fente capillaire (24) est prévu un dispositif de transport (15) pour le substrat à laquer (17) pour déplacer celui-ci au-dessus de l'extrémité supérieure de la fente capillaire (24),
caractérisé en ce que le dispositif de transport a la forme d'un dispositif de transport linéaire (15) avec un dispositif d'arrêt (16) pour un substrat (17) à laquer en forme de plaque ou de disque, pour éloigner celui-ci, lors du laquage ou de l'enduction, sans contact avec les bords de la fente capillaire (24) à une distance minime, au-delà de celle-ci et de ses bords.

2. Dispositif selon la revendication 1, caractérisé en ce que la distance entre la fente capillaire (24) et le substrat (17) lors de l'enduction est plus petite que 0,2 mm.

3. Dispositif selon la revendication 1 ou 2, caractérisé en ce que la fente capillaire (24) présente deux plaques parallèles (19, 20) qui plongent toutes deux dans une rigole (12) contenant un fluide liquide d'enduction.

4. Dispositif selon la revendication 2 ou 3, caractérisé en ce que la fente capillaire (24) a moins de 0,5 mm de large.

5. Dispositif selon un ou plusieurs des revendications précédentes, caractérisé en ce qu'un dispositif de déplacement (22) pour la modification continue de la largeur de la fente capillaire (24) est prévu, qui permet un déplacement de la fente capillaire pendant le fonctionnement du dispositif.

6. Dispositif selon la revendication 5, caractérisé en ce que des moyens sont prévus pour ouvrir la fente capillaire (24) après chaque processus de laquage.

7. Dispositif selon la revendication 6, caractérisé en ce que le dispositif de déplacement (22) est configuré pour l'ouverture de la fente capillaire (24) à une largeur de 2 à 3 mm.

8. Dispositif selon la revendication 17, caractérisé en ce que des moyens sont prévus pour rétrécir la fente capillaire juste avant le début de chaque processus de laquage ou d'enduction, à une largeur de fente capillaire permettant d'exprimer une petite quantité du fluide liquide d'enduction en haut de la fente capillaire (24) et d'ainsi mettre en oeuvre le laquage ou l'enduction de la plaque ou du disque (17).

9. Dispositif selon une ou plusieurs des revendications précédentes, caractérisé en ce qu'il est pourvu d'une station automatique de chargement (31) et d'une station automatique de déchargement (32).

10. Dispositif selon une ou plusieurs des revendications précédentes, caractérisé en ce qu'il peut fonctionner avec dispositif stationnaire d'arrêt (16) et goulotte mobile d'enduction (12).

11. Utilisation d'un dispositif selon une ou plusieurs des revendications précédentes pour la fabrication d'écrans pour LCD, de masques pour la fabrication des semi-conducteurs ou de substrats semi-conducteurs ou céramiques.
